# EUROPEAN PATENT APPLICATION

(11) **EP 4 761 119 A1**
(43) Date of publication of application: **17.06.2026**
(21) Application number: 25219825.4
(22) Date of filing: 01.12.2025
(51) Int. Cl.: H03M 3/00

(54) **DELTA SIGMA MODULATOR WITH OUTPUT CONTROLLED FEEDBACK CURRENT**

(30) Priority: 05.12.2024 US 202418969976
(71) Applicant: NXP B.V., 5656 AG Eindhoven (NL)
(72) Inventor: van der KLOOSTER, Jan Daniël, 5656AG Eindhoven (NL)
(74) Representative: Schwarzweller, Thomas

(57) **Abstract**

A delta sigma modulator includes a comparator circuit with an output that provides a digital signal which is indicative of a voltage of an a signal received at its input terminal. The modulator includes a continuous-time path from the modular input terminal to an input terminal of a comparator of the comparator circuit. The modulator includes a first feedback loop connected to a first integrating node of the path that provides a first comparator circuit output controlled feedback current and a second a second feedback loop that provides a second comparator circuit output controlled feedback current to a second integrating node of the path that is connected to the input terminal of the comparator and connected to a capacitor.

## Description

### BACKGROUND OF THE INVENTION

### Field of the Invention

This invention relates to a delta sigma modulator with output controlled feedback current to an integrating node.

### Background

Delta sigma modulators may be utilized in converting analog signals to digital signals.

### Brief Description of the Drawings

The present invention may be better understood, and its numerous objects, features, and advantages made apparent to those skilled in the art by referencing the accompanying drawings.
Figure 1 is a block diagram of a prior art delta sigma modulator.
Figure 2 is a circuit diagram of a delta sigma modulator according to one embodiment of the present invention.
Figure 3 is a circuit diagram of a nonoverlap circuit used in a delta sigma modulator according to one embodiment of the present invention.
Figure 4 is a timing diagram of the delta sigma modulator of Figure 2 according to one embodiment of the present invention.
Figure 5 is a circuit diagram of a delta sigma modulator according to one embodiment of the present invention.
Figure 6 is a timing diagram of the delta sigma modulator of Figure 5 according to one embodiment of the present invention.
Figure 7 is a circuit diagram of a delta sigma modulator according to one embodiment of the present invention.
Figure 8 is a circuit diagram of a delta sigma modulator according to one embodiment of the present invention.
Figure 9 is a circuit diagram of a delta sigma modulator according to one embodiment of the present invention.
Figure 10 is a circuit diagram of a delta sigma modulator according to one embodiment of the present invention.

The use of the same reference symbols in different drawings indicates identical items unless otherwise noted. The Figures are not necessarily drawn to scale.

### DETAILED DESCRIPTION

The following sets forth a detailed description of a mode for carrying out the invention. The description is intended to be illustrative of the invention and should not be taken to be limiting.

As disclosed herein, a delta sigma modulator includes a comparator circuit with an output that provides a digital signal which is indicative of a voltage of an a signal received at its input terminal. The modulator includes a continuous-time path from the modular input terminal to an input terminal of a comparator of the comparator circuit. The modulator includes a first feedback loop connected to a first integrating node of the path that provides a first comparator circuit output controlled feedback current and a second a second feedback loop that provides a second comparator circuit output controlled feedback current to a second integrating node of the path that is connected to the input terminal of the comparator and connected to a capacitor.

Such a configuration in some embodiments may provide for a delta sigma modulator which reduces the voltage swing at the comparator input caused by thermal noise. Such a feature may provide for improved comparator gain, which results in improved noise shaping by the delta sigma modulator.

Passive delta sigma modulators may be more power efficient than active delta sigma modulators in that they do not include active components in the loop-filter to provide gain. However, no gain in the loop-filter may result in a low voltage swing in the internal states of the loop-filter which adversely affects the noise shaping of the modulator.

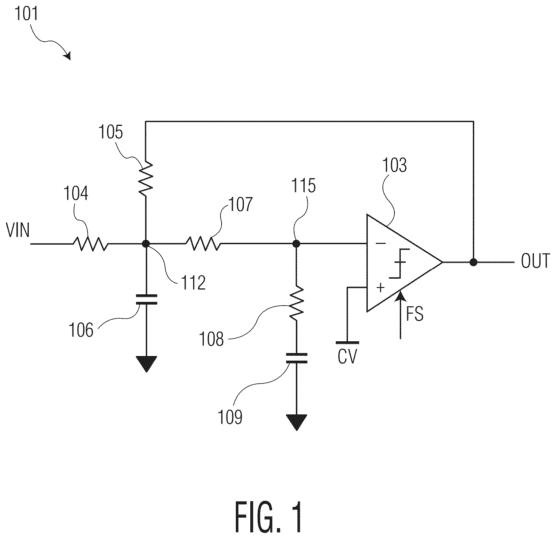

Figure 1 is a circuit diagram of a prior art delta sigma modulator 101. Modulator 101 includes an input terminal that receives an analog signal (VIN) and an output that provides a serial digital bit stream OUT provided by comparator 103. Comparator 103 includes an inverting input terminal that is coupled to the input terminal through resistor 107 and resistor 104 and is connected to integrating node 115, which is coupled to capacitor 109 through zero resistor 108. The non inverting input terminal of comparator 103 is connected to a common voltage source. The output of comparator 103 is coupled to node 112 through feedback resistor 105 to provide a feedback loop. Capacitor 106 is connected to integrating node 112 and connected to ground. During operation, resistor 108 provides a zero to the loop-filter frequency response that stabilizes the loop.

Because modulator 101 is a passive modulator in that it does not use active components (such as an amplifier) in the loop-filter to provide gain, which makes it more power efficient than an active delta sigma modulator. However, no gain in the loop-filter results in a low voltage swing in the internal nodes of the loop-filter including at the inverting input of comparator 103. Because of this low voltage swing at the input terminal of the comparator, the noise of the comparator plays a significant role in the overall noise of the modulator. Additionally, noise from the comparator is not integrated, as it is generated inside the comparator. This results in the comparator dynamically making wrong decisions, which effectively reduces the comparator gain, thereby impacting the noise shaping of the modulator.

Furthermore, resistors 107 and 108 add noise at the input terminal of the comparator, of which the high frequency components are not integrated, thereby having a significant impact on the gain of the comparator. By removing zero resistor 108, the bandwidth of resistor 107 can be limited, which significantly reduces the swing of the noise at the comparator input terminal. However, just removing resistor 108 may lead to loop instability resulting in poorer delta sigma modulator performance. Additionally, removing resistor 108 reduces the ripple at the input of comparator 103 caused by kickback from comparator 103, as the input of comparator 103 would be connected to integration capacitor 109.

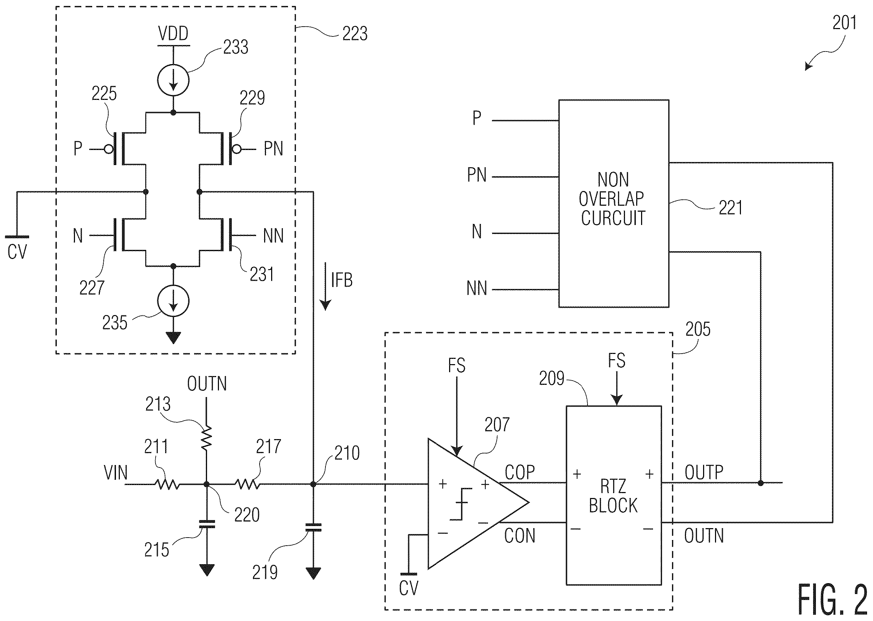

Figure 2 is a circuit diagram of a delta sigma modulator 201 according to one embodiment of the present invention. Modulator 201 includes a single ended input that includes an input terminal that receives an analog signal (VIN) and uses delta sigma modulation to produce at its output, serial output signals (OUTP, OUTN) that are indicative of the volage of VIN. In some embodiments, the output signals produce a 1 bit serial digital signal. The output of modulator 201 is provided by a comparator circuit 205 that includes a comparator 207 and a return-to-zero (RTZ) block 209. Comparator 207 is utilized as a quantizer for modulator 201. Block 209 receives the differential output signals COP and CON from the non inverting output terminal and the inverting output terminal of comparator 207, respectively, and implements a return-to-zero function to provide signals OUTP and OUTN at its non inverting output terminal and its inverting output terminal, respectively. The comparator 207 and RTZ block 209 receive a clock signal FS which defines the sampling frequency of the comparator circuit and the data cycles of the OUTP and OUTN signals. The pattern of high voltage state data cycles and low voltage state data cycles on OUTP, and inversely on OUTN, are indicative of the analog voltage at VIN. In some embodiments, the ratio of high voltage state data cycles to total data cycles of the OUTP signal (or low voltage data state cycles to total data cycles of the OUTN signal) is indicative of the analog voltage of VIN. In some embodiments, providing an output signal with a return-to-zero characteristic may reduce inter symbol interference.

The noninverting input terminal of comparator 207 is connected to integrating node 210, and the inverting input terminal of comparator 207 is connected to a common voltage (CV) source whose voltage is above ground but below VDD. In some embodiments, CV is equal to VDD/2, but may be of other values in other embodiments. Modulator 201 includes a continuous-time path from the modulator terminal input that receives the VIN signal to the non inverting input of comparator 207. The continuous-time path includes resistor 211, integrating node 220, resistor 217, and integrating node 210, which is connected to the non inverting input of comparator 207.

Integrating capacitor 219 includes one electrode connected to node 210 and another electrode connected to ground. Resistor 217 includes one terminal connected to node 210 and another terminal connected to integrating node 220. Resistor 211 includes one terminal connected to node 220 and another terminal connected to the modulator input terminal that receives the VIN signal. Capacitor 215 includes an electrode connected to node 220 and another electrode connected to ground. A feedback resistor 213 includes one terminal connected to node 220. The other terminal of feedback resistor 213 is connected to the inverting output of block 209 to implement a feedback loop for receiving a current produced by the OUTN signal over resistor 213. Accordingly, the feedback current produced by the OUTN signal is integrated with the input signal VIN at node 220 with an integrator implemented with resistor 211 and capacitor 215.

Modulator 201 includes another integrator (implemented with resistor 217 and capacitor 215) that integrates the integrated signal produced at node 220 with a comparator circuit controlled feedback current (IFB) at node 210 to generate an integrated voltage at the non inverting input terminal of comparator 207. As shown in Figure 2, capacitor 219 includes an electrode connected to node 210 and another electrode connected to ground.

The voltages at nodes 220 and 210 are described as continuous time voltages, as they continuously change based on the modulator input and feedback loop output. This differs from a discrete time implementation where the voltages of nodes 220 and 210 would be constant over defined times (as with a sampled signal).

The feedback loop that produces feedback current IFB includes a nonoverlap circuit 221 that receives the OUTP and OUTN signals from the comparator circuit 205 and produces the P, PN, N, and NN signals that are provided to the gates of PFET 225, PFET 229, NFET 227, and NFET 231, respectively, of current steering circuit 223. Current steering circuit 223 also includes a current source 233 that includes a terminal connected to voltage supply rail VDD and another terminal connected to the sources of PFETs 225 and 229. Circuit 223 includes a current source 235 including one terminal connected to ground and another terminal connected to the sources of NFETs 227 and 231. The drains of NFET 227 and PFET 225 are connected to the common voltage source and the drains of NFET 231 and PFET 229 are connected to integrating node 210 to provide the feedback current IFB. In one embodiment, VDD is at 1.8 volts and CV is at .9V, VIN ranges from 0-1.8 V, and signals N, P, PN, NN, OUTN, and OUTP range from 0-1.8 V, but these voltages may be of other values in other embodiments. In some embodiments, current source 235 may be connected to a negative voltage supply and the inverting input terminal of comparator 207 and the drains of NFET 227 and PFET 225 may be connected to ground. Current sources 233 and 235 may be implemented in a number of ways such as e.g., with a transistor having a bias voltage at its control terminal or with a current mirror. In one embodiment, the current produced by current sources 233 and 235 is in the range of 100-200 nA, but may be of other values in other embodiments. In some embodiments, the delta sigma modulator is characterized as a passive delta sigma modulator in that no gain is applied at the integration nodes (210, 220) within the loop-filter of the modulator. As shown in Figure 2, the loop-filter of the modulator 201 is implemented with resistors 211 and 217 and capacitors 215 and 219. For example, there are no amplifiers included in the loop-filter of modulator 201.

When NFET 231 is made conductive by the NN signal being at a high voltage and PFET 229 is made nonconductive by the PN signal being at a high voltage, current source 235 sinks current from node 210 (IFB is negative) to lower the voltage of node 210. This occurs in response to comparator circuit 205 indicating a positive comparison of the voltage of node 210 with the voltage CV at the sampling time (determined by clock signal FS) to produce a quantized value. When NFET 231 is made nonconductive by the NN signal being at a low voltage and PFET 229 is made conductive by the PN signal being at a low voltage, current source 233 sources current to node 210 (IFB is positive) to raise the voltage of node 210. This occurs in response to comparator circuit 205 indicating a negative comparison of the voltage of node 210 with CV at the sampling time.

Because the output of comparator circuit 205 controls whether the current IFB provided to node 210 is sinked or sourced, current IFB is characterized as being comparator circuit output controlled. Likewise, because resistor 213 is connected to an output terminal of comparator circuit 205, the feedback current provided to node 220 is also characterized as comparator circuit output controlled.

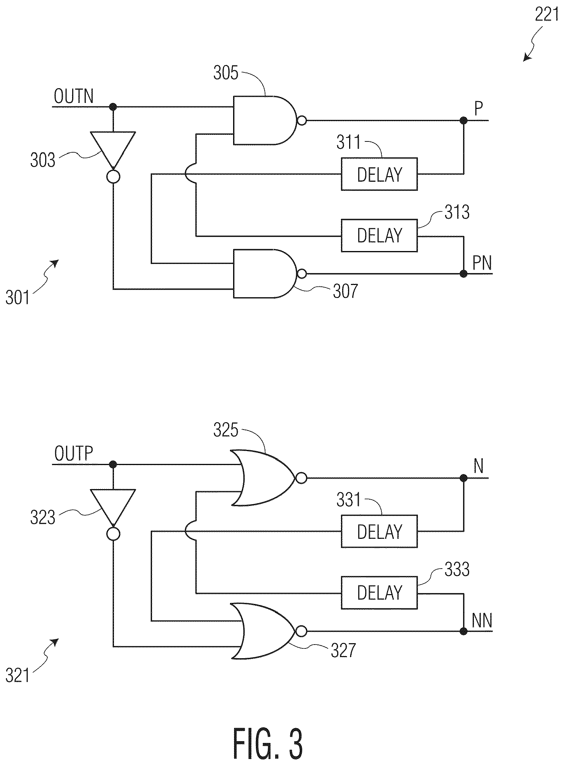

Figure 3 is a circuit diagram of nonoverlap circuit 221 according to one embodiment of the present invention. Circuit 221 includes a signal generation circuit 301 that produces the P and PN signals from the OUTN signal. Circuit 301 includes a NAND gate 305 that includes an input terminal that receives the OUTN signal and another input terminal that receives a delayed PN signal from delay element 313. NAND gate 305 provides the P signal. NAND gate 307 receives an inverted OUTN signal from inverter 303 at one input terminal and the delayed P signal from delay element 311 at its other input terminal. NAND gate 307 produces the PN signal.

Circuit 221 includes a signal generation circuit 321 that produces the N and NN signals from the OUTP signal. Circuit 321 includes a NOR gate 325 that includes an input terminal that receives the OUTP signal and another input terminal that receives a delayed NN signal from delay element 333. NOR gate 325 provides the N signal. NOR gate 327 receives an inverted OUTP signal from inverter 323 at one input terminal and the delayed N signal from delay element 331 at its other input terminal. NOR gate 327 produces the NN signal. A nonoverlap circuit may have other configurations in other embodiments.

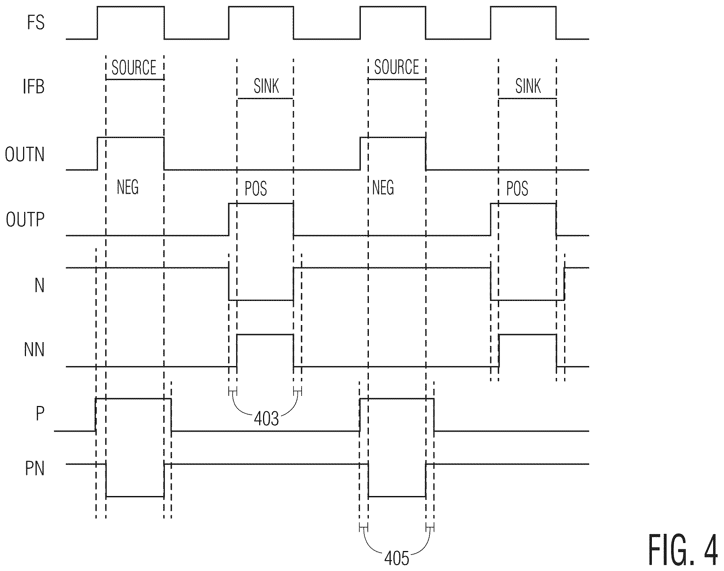

Figure 4 shows a timing diagram of the operation of delta sigma modulator 201 according to one embodiment of the present invention. The OUTN and OUTP signals are indicative of the comparisons by comparator circuit 205 of the voltage of integrating node 210 with CV that occur each rising edge of the sampling clock signal FS. A negative comparison is indicated when the OUTN signal is at a high voltage state and the OUTP signal is at a low voltage state during a high clock state of FS. A positive comparison is indicated when the OUTP signal is at a high voltage state and the OUTN signal is at a low voltage state during a high clock state of FS. As shown in Figure 4, the OUTN signal and the OUTP signal have a return-to-zero characteristic as provided by block 209 in that both signals return to a low voltage state when the FS clock signal is low. Figure 4 shows four consecutive data cycles (with four rising clock edges of FS) where the comparisons consecutively indicate a negative comparison, a positive comparison, a negative comparison, and a positive comparison. However, it is understood that the comparisons can be of any combination depending upon the changing voltage of VIN over time (which is not shown in Figure 4).

Because signal NN is responsive to the OUTP signal, signal NN is at a high voltage state to turn on NFET 231 to sink current to node 210 in response to the OUTP signal being at a high voltage state indicative of a positive comparison. Non overlapping circuit 221 delays the rise of the NN signal with respect to the rise of the OUTP signal by margin 403. Because the PN signal is responsive to the OUTN signal, the PN signal is at a low voltage state to turn on PFET 229 to source current to node 210 in response to the OUTN signal being at a high voltage state indicative of a negative comparison. Non overlapping circuit 221 delays the fall of the PN signal with respect to the rise of the OUTN signal by a margin 405.

Referring back to Figure 2, current steering circuit 223 includes PFET 225 and NFET 227 that allow the current from current sources 233 and 235 to flow to the CV source when they are not sourcing or sinking current to node 210. Referring to Figure 4 and Figure 2, NFET 227 is conductive (when the N signal is high) when NFET 231 is not conductive (when the NN signal is low) so as to allow the current from current source 235 to flow when NFET 231 is nonconductive. However, non overlapping circuit 231 provides a "guard band" margin 403 that prohibits the N signal and the NN signal from being at a high, conductive voltage state at the same time. PFET 225 is conductive (when the P signal is low) when PFET 229 is nonconductive (when the PN signal is high) so as to allow the current from current source 233 to flow when PFET 229 is nonconductive. However, nonoverlapping circuit 221 provides guard band margin 405 that prohibits the P signal and the PN signal from being at a low, conductive voltage state at the same time.

In other embodiments, current steering circuit 223 may have other configurations. Furthermore, in other embodiments, current steering circuit 223 may be replaced with other types of current generation circuits that sink and source feedback currents to node 210 responsive to the output of comparator circuit 205. Such other embodiments may include other types of nonoverlap circuits or other circuitry for controlling the current generation circuit based on the comparator circuit output signal.

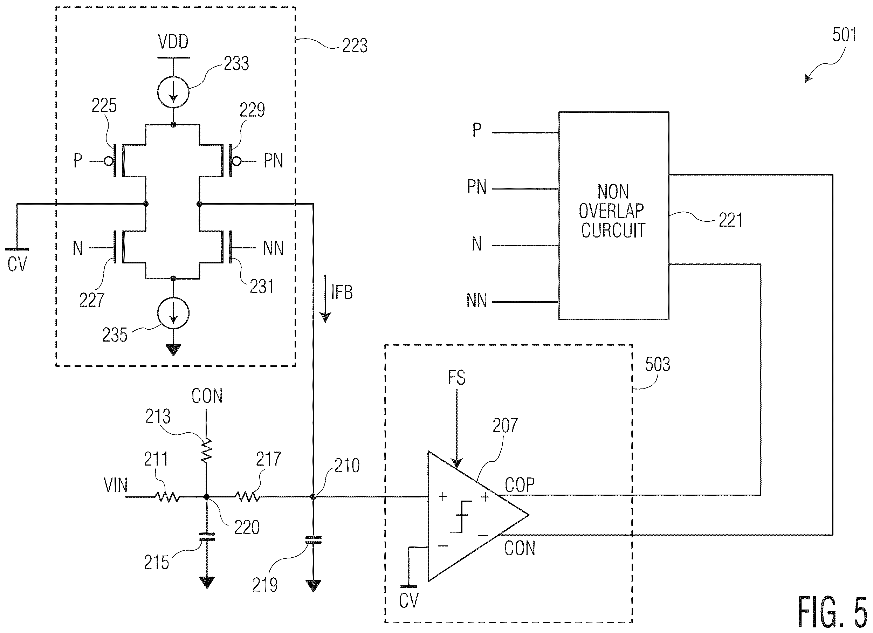

Figure 5 is circuit diagram of a delta sigma modulator 501 according to another embodiment. In Figure 5, the items with the same reference numbers as in Figure 2 perform similar functions. In the embodiment of Figure 5, comparator circuit 503 does not include a return-to-zero block similar to block 209 of Figure 2. Accordingly, the output of comparator circuit 503 (the CON and COP signals) do not have a return-to-zero characteristic.

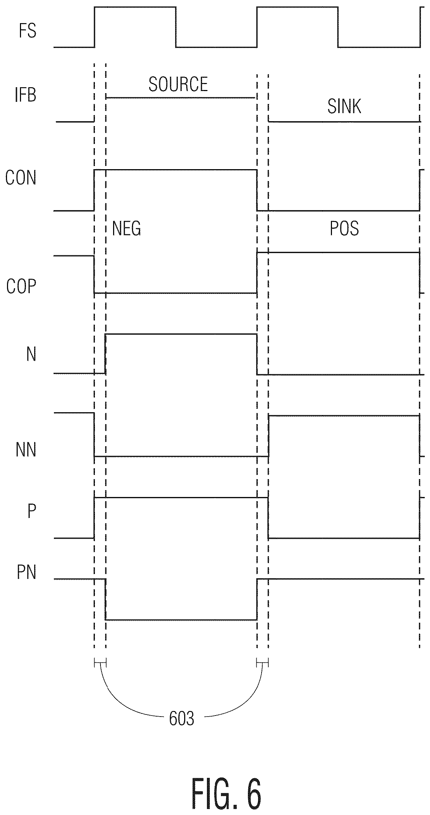

Figure 6 is a timing diagram showing the operation of delta sigma modulator 501 for two data cycles. As shown in Figure 6, the CON and COP signals do not have a return-to-zero characteristic in that they only change data states at the rising edges of the FS signal. Figure 6 shows two data cycles where current IFB is sourced to node 210 in response to a negative comparison in one cycle and where current IFB is sinked from node 210 in response to a positive comparison in following cycle. The PN signal is responsive to the CON signal to source current when the CON signal is at a high voltage state indicating a negative comparison. Overlapping circuit delays the assertion of the PN signal (to a low voltage state) in response to the rising edge of the CON signal by margin 603. The NN signal is responsive to the COP signal to sink current when the COP signal is at a high voltage state indicating a positive comparison. Overlapping circuit 221 delays the assertion of the NN signal in response to a rising edge of the COP signal by margin 603. Guard band margins 603 implemented by overlap circuit 221 prevent the P signal and the PN signal from being low at the same time and prevent the N signal and the NN signal from being high at the same time.

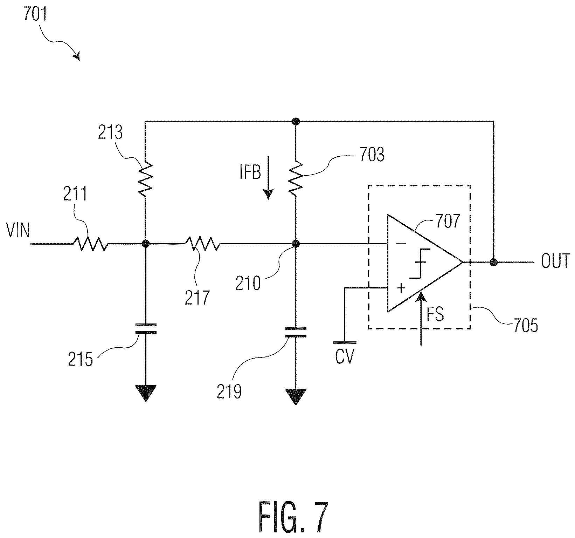

Figure 7 is a circuit diagram of a delta sigma modulator 701 according to another embodiment. In Figure 7, the items with the same reference numbers as in Figure 2 perform similar functions. Modulator 701 is different from modulator 201 of Figure 2 in that it does not utilize a current steering circuit (like current steering circuit 223) or other type of current generation circuit to provide a feedback current to integrating node 210 that is controlled by the comparator circuit output. Instead, the comparator circuit output controlled feedback current IFB is provided by connecting the output of comparator circuit 705 to a terminal of resistor 703, where the other terminal of resistor 703 is connected to node 210. In the embodiment of Figure 7, comparator circuit 705 does not include a return-to-zero block such that the output signal (OUT) does not have a return-to-zero characteristic. However, in other embodiments, circuit 705 may include a return-to-zero block. Also, integrating node 210 is connected to the inverting input of comparator 707 and the non inverting input of comparator 707 is connected to ground.

In one embodiment, resistor 211 is 100K ohms, resistor 213 is 50K ohms, resistor 217 is 100K ohms, resistor 703 is 6M ohms, capacitor 215 is 50 pF, capacitor 219 is 10 pF, and the switching frequency is 50 MHz At these values, the comparator input noise is 200 µVrms. However, these may be of other values in other embodiments.

Modulator 701 includes less circuitry than modulator 201 in that it does not include a current steering circuit or nonoverlap circuit. However, the large resistance of resistor 703 (6M ohms) makes it harder to change the feedback current at large sampling frequencies (e.g., 50 MHz).

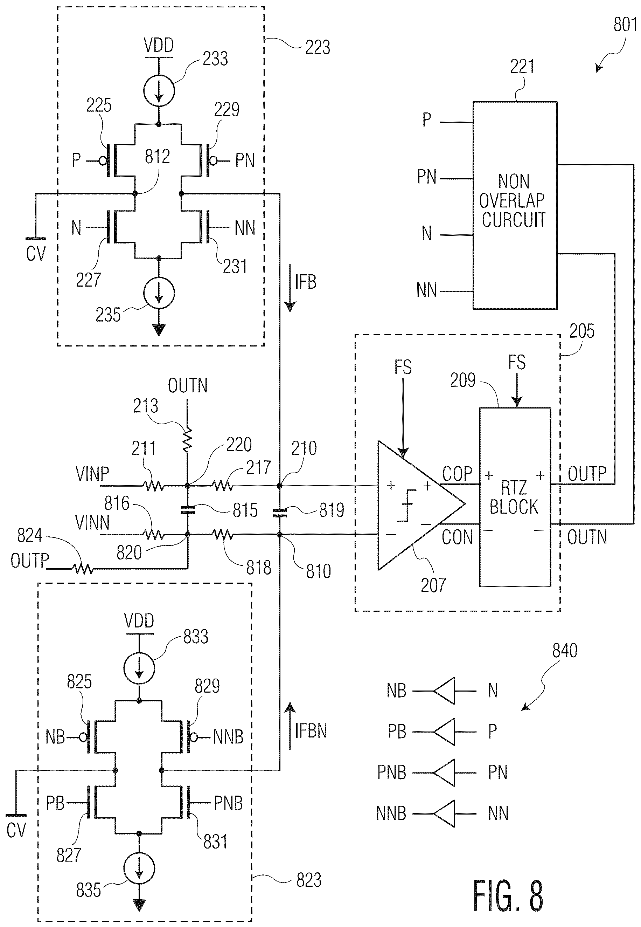

Figure 8 is a circuit diagram of a delta sigma modulator 801 according to another embodiment. In Figure 8, the items with the same reference numbers as in Figure 2 perform similar functions. In Figure 8, the input signal is a differential signal (VINN, VINP). Accordingly, modulator 801 includes an additional continuous-time path (that includes resistor 816, integrating node 820, resistor 818, and integrating node 810) from the input terminal receiving the VINN signal to the inverting input terminal of comparator 207. Modulator 801 includes a feedback loop that includes resistor 824 that is connected to the output terminal of comparator circuit 205 that provides the OUTP signal to provide a feedback current to integrator node 820 that is controlled by the comparator circuit output. Another feedback loop includes a current steering circuit 823 that provides a feedback current (IFBN) to node 810. Circuit 823 includes a current source 833 for sourcing current to node 810, PFETs 825 and 829, NFETs 827 and 831, and a current source 835 for sinking current to node 810. Current steering circuit 823 is similar to current steering circuit 223 except that circuit 823 sinks current (IFBN) from node 810 when circuit 203 sources current (IFBP) to node 210 and circuit 823 sources current (IFBN) to node 801 when circuit 203 sinks current (IFBP) from node 210. To accomplish this, modulator 801 includes four inverters 840 that invert the N, P, PN, and NN signals from nonoverlap circuit 221 to produce the inverted NB, PB, PNB, and NNB signals, respectively, that are provided to the gates of PFET 825, NFET 827, NFET 831, and PFET 829, respectively. However, in other embodiments, a modulator may include a second overlap circuit (not shown) similar to circuit 221 for producing the control signals to circuit 823. In other embodiments, a modulator may include other types of current generation circuits for producing the feedback signals.

In the embodiment shown, integrating capacitor 815 includes one electrode connected to node 220 and the other electrode connected to node 820. Integrating capacitor 819 includes one electrode connected to node 210 and the other electrode connected to node 810. However, in other embodiments, each integrating node would include its own capacitor. In some embodiments, modulator 801 may include a common mode control circuit (not shown) that regulates the common mode voltage of nodes 210 and 810 by simultaneously controlling the current of current sources 235 and 835.

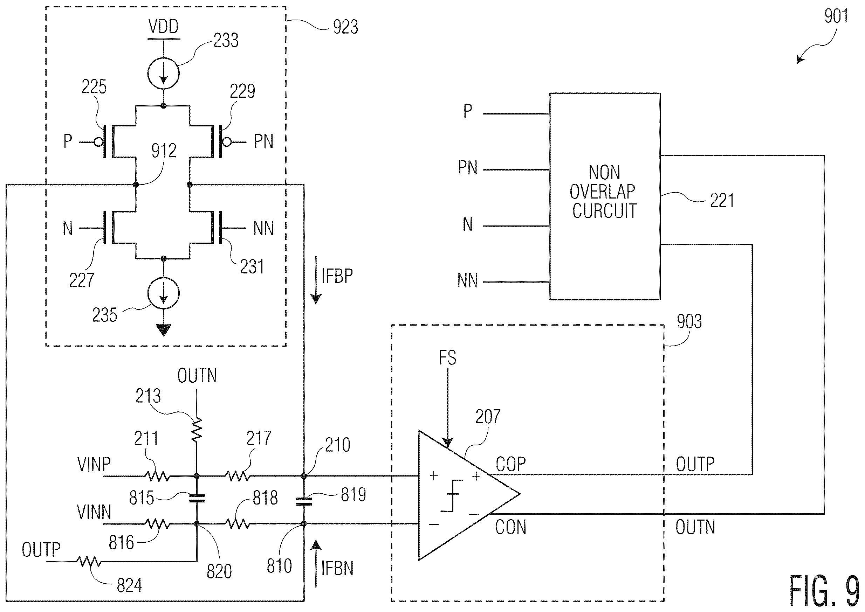

Figure 9 is a circuit diagram of a delta sigma modulator 901 according to another embodiment. In Figure 9, the items with the same reference numbers as in Figure 8 perform similar functions. Modulator 901 is similar to modulator 801 in that it receives a differential input signal (VINP, VINN). However, the comparator circuit 903 of modulator 901 does not include a return-to-zero block (e.g., similar to block 209) such that the output signals OUTP and OUTN do not have a return-to-zero characteristic. Another difference is that the drains of PFET 225 and NFET 227 of current steering circuit 923 provide the feedback current (IFBN) to node 810. Referring back to Figure 6 which is a timing diagram of the non return-to-zero embodiment of Figure 5, signals PN and N are differential to each other and signals NN and P are differential to each other. Accordingly, when current IFBP is being sinked from node 210, current IFBN is being sourced to node 810, and when current IFBP is being sourced to node 210, current IFBN is being sinked from node 810. However, in other embodiments, modulator 901 may include another current steering circuit or other type of current generation circuit for producing IFBN. In one embodiment, modulator 901 may include a common mode control circuit (not shown).

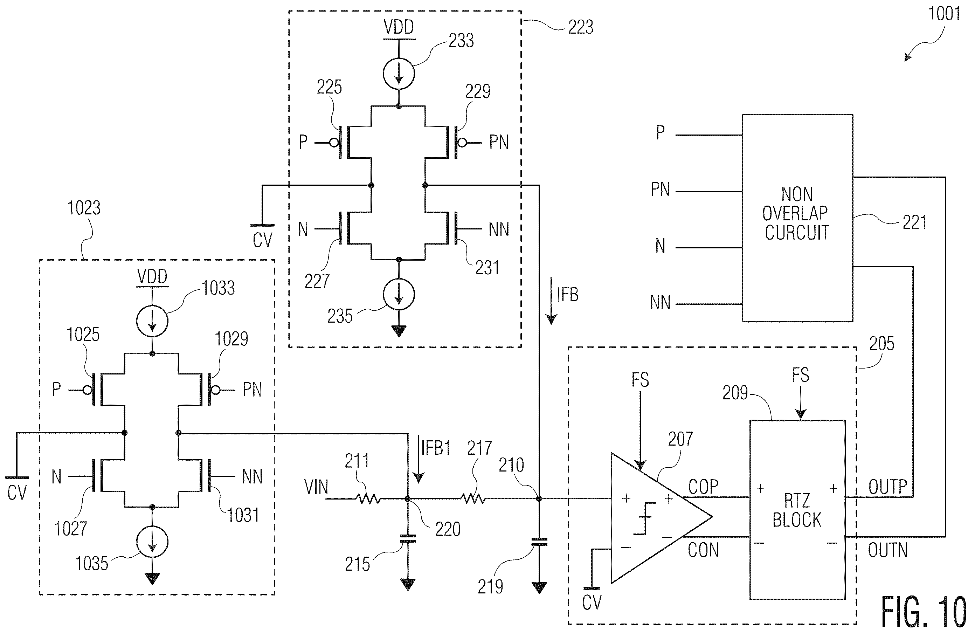

Figure 10 is a circuit diagram of a delta sigma modulator 1001 according to another embodiment. In Figure 10, the items with the same reference numbers as in Figure 2 perform similar functions. Modulator 1001 of Figure 10 differs from modulator 201 of Figure 2 in that it includes a current steering circuit 1023 for providing a feedback current (IFB1) to integrating node 220 that is comparator circuit output controlled.

Current steering circuit 1023 includes NFETs 1027 and 1031, PFETs 1025 and 1029, current source 1033 for sourcing current to node 220, and current source 1035 for sinking current from node 220. Circuit 1023 is responsive to the P, N, PN, and NN signals in a similar manner as circuit 223 such that both currents IFB and IFB1 are sinking currents at the same time and are sourcing currents at the same time. However, current sources 1033 and 1035 provide a greater amount of source current and sink current, respectively, than current sources 233 and 235, respectively. In one embodiment, the currents from sources 1033 and 1035 are 40 times greater than the currents from sources 233 and 235. In other embodiments, modulator 1001 may implement a non return-to-zero comparator circuit (similar to comparator circuit 503 of Figure 5). In other embodiments, modulator 1001 may be configured to receive a differential input signal like modulators 801 and 901 where it would include two additional current steering circuits and a second continuous-time path.

In other embodiments, the modulators described herein may include other circuitry, have other configurations, and/or operate differently. For example, other embodiments may utilize other types of transistors. Also in some embodiments, the resistors may be replaced by other types of resistive circuits such as with transistors with control terminals biased by fixed voltages.

The modulators shown and described herein may be used in a number of different applications for providing a digital indication of a single ended voltage or a differential voltage. Such modulators can be used in a number of systems such as e.g., computers, cell phones, automotive electronics, wearables, IOT systems, industrial, embedded systems, or communications systems.

Providing feedback current (IFB) to an integrating node connected to a comparator input terminal and connected to an integrating capacitor, may in some embodiments, provide a loop-filter with a zero at the integrating node at the comparator terminal input which may act to stabilize the delta sigma loop-filter of a passive delta sigma modulator. Such a configuration may allow for the removal of a zero resistor (e.g., resistor 108) as described above with respect to the prior art modulator of Figure 1. Removing a zero resistor (such as resistor 108 in Figure 1) may allow for the high frequency noise of the integrating resistor (e.g., resistor 217) to be filtered by the integrating capacitor (e.g., capacitors 219, 819), which is connected to an input terminal of the comparator (e.g., comparators 207, 707), which reduces the thermal noise generated voltage swing at the input terminal of the comparator. Additionally, the noise generated by the zero resistor (resistor 108) may be removed as well. The reduced voltage swing increases the comparator gain, improving the noise shaping of the delta sigma modulator. However, the downside of removing the zero resistor (resistor 108) is that it can lead to instability of the delta sigma modulator. The embodiments described herein include a feedback loop connected to the integration node (210) that provides a zero for loop stability. This can be done without a significant increase in voltage swing from thermal noise, as the integrating capacitor (e.g., capacitor 219, 819) is connected to the integrating node 210. High frequency noise from the feedback loop or integrator resistor (e.g., resistor 217) is filtered by the integrating capacitor (e.g., capacitor 219, 819) that is connected to the input terminal of the comparator (e.g., comparators 207, 707). Simulations of some embodiments have shown an 11 dB improvement in SNR as compared to a prior art delta sigma modulator such as the type shown in Figure 1. Consequently, the configurations described here may provide for an improved delta sigma modulator such as an improved passive delta sigma modulator, which may be beneficial, especially in low power applications.

Furthermore, noise shaping of the modulators described herein may be further improved due to the implementation of a continuous-time path from the modulator input to the comparator input as opposed to a discrete-time path. Using discrete-time implementations makes it more difficult achieve high signal to noise ratios, mainly because of charge injection and timing issues. Larger switched capacitors would mitigate this, but require the integration capacitors to scale accordingly, which would require increased integrated circuit space. Accordingly, utilizing a continuous-time input path (as opposed to a discrete-time path) in the embodiments described herein may reduce the complexity of the circuit driving the delta sigma modulator input, as it is resistive, rather than utilizing a sampled capacitor.

As used herein, one item is "coupled" to another item either by being connected to the other item or by being coupled in a current path or in a signal path through at least one further item. For example, in Figure 2, resistor 211 is coupled to node 210 through resistor 217. Resistor 211 is also coupled to resistor 217 by one of its terminals being connected to a terminal of resistor 217. A gate is a control terminal of a FET. A drain and source are current terminals of a FET. A continuous-time path is a path with no switches in the path that are configured to open and close during operation of the circuit.

Features specifically shown or described with respect to one embodiment set forth herein may be implemented in other embodiments set forth herein.

In some embodiments, a delta sigma modulator circuit includes a circuit input terminal, configured to receive a first input signal and a comparator circuit including a comparator. The comparator including a first input terminal coupled to the circuit input terminal by a continuous-time path, the comparator circuit including an output to provide a digital signal indicative of a voltage of the first input signal. The delta sigma modulator circuit includes a first integrating node in the continuous-time path, a first feedback loop connected to the first integrating node and configured to provide a first feedback current to the first integrating node, the first feedback current is characterized as being controlled by the output of the comparator circuit, a second integrating node in the continuous-time path and connected to the first input terminal of the comparator, a capacitor including a first electrode connected to the second integrating node, and a second feedback loop connected to the second integrating node, the second feedback loop configured to provide a second feedback current to the second integrating node. The second feedback current is characterized as being controlled by the output of the comparator circuit.

In further embodiments, the continuous-time path is configured to provide a continuous-time voltage to the first input terminal of the comparator, wherein the comparator is configured to compare the continuous-time voltage in response to a sampling clock signal.

In further embodiments, the second feedback loop includes a current generation circuit responsive to the output of the comparator circuit, the current generation circuit is configured to sink current from the second integrating node in response to the output of the comparator circuit being at a first output state and configured to source current to the second integrating node in response to the output of the comparator being at a second output state.

In further embodiments, the output of the comparator circuit includes a first output terminal and a second output terminal, and the current generation circuit including a first transistor, the first transistor is made conductive to source current to the second integrating node responsive to the first output terminal and including a second transistor, the second transistor is made conductive to sink current from the second integrating node responsive to the second output terminal.

In further embodiments, the first transistor is made conductive to source current to the second integrating node responsive to the first output terminal indicating a negative comparison by the comparator of its first input terminal and the second transistor is made conductive to sink current from the second integrating node responsive to the second output terminal indicating a positive comparison by the comparator of its first input terminal.

In further embodiments, the current generation circuit includes a third transistor being of a same conductivity type as the first transistor and includes a fourth transistor being of a same conductivity type as the second transistor, the first transistor and the second transistor are connected in series in a first circuit path and the third transistor and the fourth transistor are connected in series in a second circuit path, the first circuit path and the second circuit path are connected in parallel, the current generation circuit provides the second feedback current at a node of the first circuit path between the first transistor and the second transistor. The current generation circuit is characterized as current steering circuit. The second feedback loop further comprising a nonoverlap circuit, the nonoverlap circuit including a first input terminal coupled to the first output terminal, a second input terminal coupled to the second output terminal, a first output terminal coupled to a control terminal of the first transistor and is responsive to the first output terminal of the comparator circuit, a second output terminal coupled to a control terminal of the second transistor and is responsive to the second output terminal of the comparator circuit, a third output terminal coupled to a control terminal of the third transistor and is responsive to the first output terminal of the comparator circuit, a fourth output terminal coupled to a control terminal of the fourth transistor and is responsive to the second output terminal of the comparator circuit. The nonoverlap circuit drives its first output terminal and its third output terminal to prevent the first transistor and the third transistor from being conductive at the same time by a margin. The nonoverlap circuit drives its second output terminal and its fourth output terminal to prevent the second transistor and the fourth transistor from being conductive at the same time by a margin.

In further embodiments, the first feedback loop includes a second current generation circuit responsive to the output of the comparator circuit, the second current generation circuit is configured to sink current from the first integrating node in response to the output of the comparator circuit being in the first output state and configured to source current to the first integrating node in response to the output of the comparator being in the second output state.

In further embodiments, the second current generation circuit is configured to sink a greater amount of current from the first integrating node than the current generation circuit from the second integrating node and configured to source a greater amount of current to the first integrating node than the current generation circuit to the second integrating node.

In further embodiments, the second feedback loop includes a resistive circuit that includes a first terminal coupled to the output of the comparator circuit and a second terminal connected the second integrating node.

In further embodiments, the delta sigma modulator circuit is characterized as a passive delta signal modulator circuit.

In further embodiments, the delta sigma modulator circuit further includes a second circuit input terminal, configured to receive a second input signal, wherein the first input signal and the second input signal implement a differential signal, wherein the second circuit input terminal is coupled to a second input terminal of the comparator by a second continuous-time path, a third integrating node in the second continuous-time path, a third feedback loop connected to the third integrating node and configured to provide a third feedback current to the third integrating node, the third feedback current is characterized as being controlled by the output of the comparator circuit, a fourth integrating node in the second continuous-time path connected to the second input terminal of the comparator, a fourth feedback loop connected to the fourth integrating node, the fourth feedback loop configured to provide a fourth feedback current to the fourth integrating node, the fourth feedback current is characterized as being controlled by the output of the comparator circuit.

In further embodiments, the fourth feedback loop includes a current generation circuit responsive to the output of the comparator circuit, the current generation circuit is configured to sink current from the fourth integrating node in response to the output of the comparator circuit being in a first output state and configured to source current to the fourth integrating node in response to the output of the comparator circuit being in a second output state.

In further embodiments, the second feedback loop includes the current generation circuit, the current generation circuit is configured to source current to the second integrating node in response to the output of the comparator circuit being in the first output state and configured to sink current from the second integrating node in response to the output of the comparator circuit being in the second output state.

In further embodiments, the delta sigma modulator circuit further includes the capacitor includes a second electrode connected to the fourth integrating node.

In further embodiments, the delta sigma modulator circuit further includes a second capacitor including a first electrode connected to the second integrating node.

In further embodiments, the comparator circuit includes return-to-zero circuitry that implements a return-to-zero characteristic for the output of the comparator circuit.

In further embodiments, the output of the comparator circuit is characterized as not having a non return-to-zero characteristic.

In other embodiments, a method of operating a passive delta sigma modulator includes providing an input signal to a circuit input terminal of a passive delta sigma modulator circuit, the circuit input terminal is coupled in a continuous-time path to an input terminal of a comparator of a comparator circuit of the passive delta sigma modulator circuit. The method includes providing a first feedback current by a first feedback loop to a first integrating node of the continuous-time path, the first feedback current is characterized as being controlled by an output of the comparator circuit. The method includes providing a second feedback current by a second feedback loop to a second integrating node of the continuous-time path, the second feedback current is characterized as being controlled by the output of the comparator circuit, the second integrating node is connected to the input terminal of the comparator and to an electrode of a capacitor. The method includes providing at the output of the comparator circuit, a digital signal indicative of a voltage of the input signal.

In further embodiments, the providing the second feedback current includes sinking current from the second integrating node by a current generation circuit in response to the output of the comparator circuit being in a first output state and sourcing current to the second integrating node by the current generation circuit in response to the output of the comparator being in a second output state.

In further embodiments, the output of the comparator circuit including a first output terminal and a second output terminal, the current generation circuit includes a first transistor, and a second transistor, and the first transistor is made conductive responsive to the first output terminal to source current to the second integrating node and the second transistor is made conductive responsive to the second output terminal to sink current from the second integrating node.

While particular embodiments of the present invention have been shown and described, it will be recognized to those skilled in the art that, based upon the teachings herein, further changes and modifications may be made without departing from this invention and its broader aspects, and thus, the appended claims are to encompass within their scope all such changes and modifications as are within the true scope of this invention.

## Claims

1. A delta sigma modulator circuit, comprising:
a circuit input terminal, configured to receive a first input signal;
a comparator circuit including a comparator, the comparator including a first input terminal coupled to the circuit input terminal by a continuous-time path, the comparator circuit including an output to provide a digital signal indicative of a voltage of the first input signal;
a first integrating node in the continuous-time path;
a first feedback loop connected to the first integrating node and configured to provide a first feedback current to the first integrating node, the first feedback current is characterized as being controlled by the output of the comparator circuit;
a second integrating node in the continuous-time path and connected to the first input terminal of the comparator;
a capacitor including a first electrode connected to the second integrating node;
a second feedback loop connected to the second integrating node, the second feedback loop configured to provide a second feedback current to the second integrating node, the second feedback current is characterized as being controlled by the output of the comparator circuit.

2. The delta sigma modulator circuit of claim 1 wherein the continuous-time path is configured to provide a continuous-time voltage to the first input terminal of the comparator, wherein the comparator is configured to compare the continuous-time voltage in response to a sampling clock signal.

3. The delta sigma modulator circuit of claim 1 or 2 wherein the second feedback loop includes a current generation circuit responsive to the output of the comparator circuit, the current generation circuit is configured to sink current from the second integrating node in response to the output of the comparator circuit being at a first output state and configured to source current to the second integrating node in response to the output of the comparator being at a second output state.

4. The delta sigma modulator circuit of claim 3 wherein:
the output of the comparator circuit includes a first output terminal and a second output terminal;
the current generation circuit including a first transistor, the first transistor is made conductive to source current to the second integrating node responsive to the first output terminal and including a second transistor, the second transistor is made conductive to sink current from the second integrating node responsive to the second output terminal.

5. The delta sigma modulator circuit of claim 4 wherein the first transistor is made conductive to source current to the second integrating node responsive to the first output terminal indicating a negative comparison by the comparator of its first input terminal and the second transistor is made conductive to sink current from the second integrating node responsive to the second output terminal indicating a positive comparison by the comparator of its first input terminal.

6. The delta sigma modulator circuit of claim 4 or 5 wherein:
the current generation circuit includes a third transistor being of a same conductivity type as the first transistor and includes a fourth transistor being of a same conductivity type as the second transistor, the first transistor and the second transistor are connected in series in a first circuit path and the third transistor and the fourth transistor are connected in series in a second circuit path, the first circuit path and the second circuit path are connected in parallel, the current generation circuit provides the second feedback current at a node of the first circuit path between the first transistor and the second transistor;
the current generation circuit is characterized as current steering circuit;
the second feedback loop further comprising a nonoverlap circuit, the nonoverlap circuit including:
a first input terminal coupled to the first output terminal;
a second input terminal coupled to the second output terminal;
a first output terminal coupled to a control terminal of the first transistor and is responsive to the first output terminal of the comparator circuit;
a second output terminal coupled to a control terminal of the second transistor and is responsive to the second output terminal of the comparator circuit;
a third output terminal coupled to a control terminal of the third transistor and is responsive to the first output terminal of the comparator circuit;
a fourth output terminal coupled to a control terminal of the fourth transistor and is responsive to the second output terminal of the comparator circuit;
the nonoverlap circuit drives its first output terminal and its third output terminal to prevent the first transistor and the third transistor from being conductive at the same time by a margin;
the nonoverlap circuit drives its second output terminal and its fourth output terminal to prevent the second transistor and the fourth transistor from being conductive at the same time by a margin.

7. The delta sigma modulator circuit of claim 3, or any of claims 4 to 6 when dependent on claim 3, wherein the first feedback loop includes a second current generation circuit responsive to the output of the comparator circuit, the second current generation circuit is configured to sink current from the first integrating node in response to the output of the comparator circuit being in the first output state and configured to source current to the first integrating node in response to the output of the comparator being in the second output state.

8. The delta sigma modulator circuit of claim 7 wherein the second current generation circuit is configured to sink a greater amount of current from the first integrating node than the current generation circuit from the second integrating node and configured to source a greater amount of current to the first integrating node than the current generation circuit to the second integrating node.

9. The delta sigma modulator circuit of any preceding claim wherein the second feedback loop includes a resistive circuit that includes a first terminal coupled to the output of the comparator circuit and a second terminal connected the second integrating node.

10. The delta sigma modulator circuit of any preceding claim wherein the delta sigma modulator circuit is characterized as a passive delta signal modulator circuit.

11. The delta sigma modulator circuit of any preceding claim further comprising:
a second circuit input terminal, configured to receive a second input signal, wherein the first input signal and the second input signal implement a differential signal, wherein the second circuit input terminal is coupled to a second input terminal of the comparator by a second continuous-time path;
a third integrating node in the second continuous-time path;
a third feedback loop connected to the third integrating node and configured to provide a third feedback current to the third integrating node, the third feedback current is characterized as being controlled by the output of the comparator circuit;
a fourth integrating node in the second continuous-time path connected to the second input terminal of the comparator;
a fourth feedback loop connected to the fourth integrating node, the fourth feedback loop configured to provide a fourth feedback current to the fourth integrating node, the fourth feedback current is characterized as being controlled by the output of the comparator circuit.

12. The delta sigma modulator circuit of claim 11 wherein the fourth feedback loop includes a current generation circuit responsive to the output of the comparator circuit, the current generation circuit is configured to sink current from the fourth integrating node in response to the output of the comparator circuit being in a first output state and configured to source current to the fourth integrating node in response to the output of the comparator circuit being in a second output state.

13. A method of operating a passive delta sigma modulator, the method comprising:
providing an input signal to a circuit input terminal of a passive delta sigma modulator circuit, the circuit input terminal is coupled in a continuous-time path to an input terminal of a comparator of a comparator circuit of the passive delta sigma modulator circuit;
providing a first feedback current by a first feedback loop to a first integrating node of the continuous-time path, the first feedback current is characterized as being controlled by an output of the comparator circuit;
providing a second feedback current by a second feedback loop to a second integrating node of the continuous-time path, the second feedback current is characterized as being controlled by the output of the comparator circuit, the second integrating node is connected to the input terminal of the comparator and to an electrode of a capacitor;
providing at the output of the comparator circuit, a digital signal indicative of a voltage of the input signal.

14. The method of claim 13 wherein the providing the second feedback current includes sinking current from the second integrating node by a current generation circuit in response to the output of the comparator circuit being in a first output state and sourcing current to the second integrating node by the current generation circuit in response to the output of the comparator being in a second output state.

15. The method of claim 14 wherein:
the output of the comparator circuit including a first output terminal and a second output terminal;
the current generation circuit includes a first transistor, and a second transistor;
the first transistor is made conductive responsive to the first output terminal to source current to the second integrating node and the second transistor is made conductive responsive to the second output terminal to sink current from the second integrating node.
